# EUROPEAN PATENT APPLICATION

(11) **EP 2 387 297 A2**
(43) Date of publication of application: **16.11.2011**
(21) Application number: 11165219.4
(22) Date of filing: 09.05.2011
(51) Int. Cl.: H05K 5/02

(54) **Plastic enclosure and joint of a plastic enclosure**

(30) Priority: 11.05.2010 FI 20105513
(71) Applicant: Ensto Finland Oy, 06150 Porvoo (FI)
(72) Inventor: Tuomisto, Timo, FI-00760, Helsinki (FI); Meriluoto, Kimmo, FI-01490, Vantaa (FI); Mattila, Reijo, FI-01400, Vantaa (FI)
(74) Representative: Jyrämä, Hanna-Leena Maria

(57) **Abstract**

The invention relates to a plastic enclosure (1), which comprises a base section (3) and a lid section (4) which form, the enclosure being closed, a base (33) and a lid (43) of the enclosure, and walls (45, 35) remaining between said lid (43) and base (33), whereby on an inner surface (33a, 43a) of the enclosure base (33) or lid (43) or an inner surface of a joining section (7) used for the mutual joining of the enclosure (1) base section (3) and lid section (4) abuts at least one sleeve-like array (2) protruding from the plane of the inner surface/inner surfaces in question at an angle of about 90 degrees which is arranged to receive a fastening element with an external thread (6). From an inner surface (2a) of the sleeve-like array (2) protrudes in the direction of a radius (2r) of the sleeve-like array (2) a set of elongated grooves (200) in the longitudinal direction of the sleeve-like section.

## Description

The invention relates to a plastic enclosure according to the preamble of claim 1.

The invention also relates to a joint according to the preambles of claims 13 and 14.

Plastic instrument and equipment enclosures are commonly used in various electrical, lighting and data networks and in power and compressed air wirings to protect accessories and attachments placed within the enclosures. These enclosures can be fastened to different accessories, such as installation rails. These enclosures include a lid section and a base section which are either joinable to each other with fastening elements or alternatively the lid section and the base section are mutually detachably joined by means of a hinge and latch mechanism.

The fastening of various accessories and attachments, the mutual fastening of instrument and equipment enclosures and the fastening of hinge and latch mechanisms to the base and lid sections of the plastic enclosure commonly employ screw elements provided with an external thread with so-called screw towers used as their counterparts. As the instrument and equipment enclosures are produced in series, the screw towers are usually manufactured by die-casting and of the same plastic material as the other enclosure. The screw towers intended as the counterparts of the screw elements are elongated sleeve-like arrays with a circular cross-section profile, that is, towers which support themselves from one end to the plane surface of the plastic enclosure or its hinge or locking mechanism.

The applicant has found that there sometimes can occur problems in the durability of die-cast screw towers manufactured of hard polycarbonate plastic. When plastic enclosures are assembled in series, the screw elements are mechanically driven to the screw towers with specific standard torque. This might cause fractures in the screw towers either immediately or later during use. The above problem being the starting point, the object of the invention is to provide a screw tower of polycarbonate plastic more durable than earlier.

In the present invention, the solution of the above problem is based on the fact that screw towers manufactured of polycarbonate plastic are provided with elongated grooves running within the screw towers.

More specifically, the invention is characterised by what is presented in the characterising part of claim 1, the characterising part of claim 13 and the characterising part of claim 14.

The plastic enclosure according to the invention comprises a base section and a lid section which form, the enclosure being closed, a base and a lid of the enclosure, and walls remaining between said lid and base, whereby on an inner surface of the enclosure base or lid or an inner surface of a joining section used for the mutual joining of the enclosure base section and lid section abuts at least one sleeve-like array protruding from the plane of the inner surface/inner surfaces in question at an angle of about 90 degrees which is arranged to receive a fastening element with an external thread. From the inner surface of the sleeve-like array protrudes in the direction of the radius of the sleeve-like array a set of elongated grooves in the longitudinal direction of the sleeve-like section.

In an advantageous embodiment of the invention, the sleeve-like section is manufactured of die-castable hard plastic.

Advantageously, the plastic is polycarbonate-based plastic with the bending strength of about 8,000-9,500 psi and the Rockwell hardness of above about M70. Polycarbonate plastic has a low notch strength, whereby it might fracture even though the torque of the screw were kept otherwise within allowed limits. Even thought the invention is based on problems observed in polycarbonate-based plastic towers and their solution described above, the applicant has noticed that also other screw towers than the ones manufactured of polycarbonate-based plastics can have the above problems, whereby the screw tower fractures immediately or after some time has passed when driving the fastening element provided with an external thread within them. Hard plastics refer here to thermoplastic, die-castable plastics with the Rockwell hardness of above M60, advantageously above M70, and the bending strength of above about 7,000. Such plastics are among others polyether ketones with the bending strength of typically above 14,000 psi and the Rockwell hardness R126-M99, and some ABS (acrylonitrile-butadiene-styrene) grades with the bending strength of typically 7,000-8,000 psi and the Rockwell hardness R110-115.

The plastic enclosure refers here to a closable enclosure manufactured of a hard plastic grade, formed of a base section and a lid section, the interior space of which can be provided with various accessories, attachments and wirings.

The base section of the plastic enclosure refers here to a section of the enclosure formed of a planar base and advantageously planar base walls of the same height, joined to the base, diverging from the base substantially at a straight angle. The height of the base section is defined by the distance of the inner surface of the base from the upper edge of its base walls.

The lid section of the plastic enclosure refers here to a section of the enclosure formed of a planar lid and advantageously planar lid walls of the same height, possibly joined to the lid, diverging from the lid substantially at a straight angle.

The interior space of the plastic enclosure refers here to a space remaining between the base section and the lid section joined to each other. The depth of the interior space is defined by the combined height of the base walls of the base section and possible lid walls of the lid section.

Advantageously, the sleeve-like array is a screw tower which is a tower-like, rod-like or tube-like array with a circular cross-section profile, hollow from inside, the first, lower end (often closed end) of which abuts on a plane surface and the second, free end directs at a 90-degree angle away from said plane surface. The screw tower is arranged to receive and guide a screw of a fastening element provided with an external thread.

Grooves protruding from the inner surface of the sleeve-like array are part of a grooving on the inner walls of the sleeve-like array. The grooving includes said set of straight grooves running on the inner surface of the sleeve-like array, in the longitudinal direction of the screw tower, which protrude in the direction of the radius of the sleeve-like array such that adjacent grooves are always at the same peripherical distance from each other and the grooving further comprises a set of slots running between said grooves, including the inner surface of the sleeve-like array.

The grooving refers here to a structure running on the inner surface of the sleeve-like array i.e. on the inner surface of an opening going through the sleeve-like array which consists of a set of substantially straight grooves in the longitudinal direction of the sleeve-like array which simultaneously are at a peripherical distance of the inner surface of the sleeve-like array from each other and from the slots remaining between the grooves.

Each groove in turn consists of a straight, elongated projection extending in the direction of the hole radius at a specific distance from the inner surface of a hole going in the middle of the sleeve-like array. The depth of the groove is then its dimension in the longitudinal direction of the sleeve-like array and the height of the groove is the dimension from the inner surface of the screw tower in the direction of the hole radius. Each groove then has two walls which are fastened first on the inner surface of the sleeve-like array and second on the front edge of the groove.

The walls of each slot included in the grooving always consist of the walls of two adjacent grooves and the base of the slot consists of the inner surface of the sleeve-like array remaining between said grooves.

The plane surface refers to an inner surface of the base section, lid section or joining section, whereby the joining section is a latch section or a hinge section.

In another advantageous embodiment, the sleeve-like array supports itself on the base surface of the enclosure base section or on the inner surface of the lid of the enclosure lid section and projects from said base surface or inner surface of the lid of the lid section at a 90-degree angle in the direction of the interior space.

In a further advantageous embodiment, the joining section of the enclosure is a hinge section used for the mutual hinging of the base section and the lid section from the inner surface of which projects at a 90-degree angle in the direction of the enclosure the sleeve-like array when the hinge section is installed in the enclosure.

In an additional advantageous embodiment, the joining section of the enclosure is a latch section used for the mutual locking of the base section and the lid section of the enclosure from the inner surface of which projects at a 90-degree angle in the direction of the enclosure the sleeve-like array when the latch section is installed in the enclosure.

Advantageously, the lower end of the sleeve-like array supports itself on the plane surface and is provided with a butt. The butt refers here to a reinforcement of the closed end of the sleeve-like section between the sleeve-like array and its plane surface on which said sleeve-like section supports itself. Due to the reinforced butt, the sleeve-like section can be located without additional support protruding from the inner surface of the enclosure or its joining section. On the outer surface of the sleeve-like array, there can be other shapes, such as e.g. a slot for an O ring or an equivalent seal.

The purpose of the grooving is first to guide the fasteing element provided with an external thread to run controlledly within the sleeve-like array (e.g. screw tower) such that the longitudinal centre line of said fastening element goes as close as possible to the longitudinal centre line of the sleeve-like array (i.e. the fastening element is centred on the centre line of the sleeve-like array).

The purpose of the grooves of the grooving is also to decrease the torque by which the fastening element provided with an external thread, such as a screw, can be driven within the sleeve-like array, such as a screw tower. The elongated grooves running on the inner surface of the sleeve-like section efficiently decrease the torque required to drive the fastening element and thus the bending and torsional stress applied on the housing of the screw tower by the screw driven within the screw tower, because the grooving receives most of the strain caused by the fastening element. The torque also decreases due to the fact that the friction between the fastening element and the grooving is smaller than the friction between the fastening element and the inner surface of the screw tower in a traditional screw tower.

When the torque required to drive the fastening element decreases to a specific level predictable beforehand, the important advantage is provided that the tension force formed by the fastening element driven within the screw tower, required to create the fastening between two pieces, can be controlled better.

When the torque required to drive the fastening element decreases, it provides the better durability of the base of the fastening element, such as a screw.

More specifically, the number of grooves, the shape of their cross-section profile and the height of the grooves in the direction of the radius of the hole going through the sleeve-like array are chosen advantageously such that material displaced by the external thread of the fastening element from the grooves of the grooving is able to be carried along to the slots between the grooves, the fastening element still forming a permanent friction joint with the grooves of the grooving.

To centre the fastening element on the centre line of the sleeve-like array, the outer diameter of the fastening element is chosen advantageously smaller than the inner diameter of the sleeve-like array. Then, the fastening element is not substantially in contact with the inner surface of the sleeve-like array when the fastening element is centred on the longitudinal centre line of the sleeve-like diameter by means of the groovings. On the other hand, the outer diameter of the fastening element should be so large that the external thread of the fastening element set on the centre line of the hole of the screw tower in the longitudinal direction extends within the grooving when the grooving is seen from said centre line.

Equivalently, the height of the grooves being on the inner surface of the hole going through the sleeve-like array in relation to the inner and outer diameter of the fastening element is advantageously arranged such that the fastening element being on the longitudinal centre line of the screw tower bites equally deep in each groove. The height of each groove from the inner surface of the sleeve-like array should then be chosen such that the inner diameter of the fastening element provided with an external thread, fitted in the hole going through the sleeve-like array equals at the maximum 2 times the groove height in said hole. On the other hand, the height of the groove should be chosen so large that the external thread of the fastening element extends within the grooving when the grooving is seen from said centre line.

The unthreaded part of the fastening element is thus brought into contact or close to the front edge of the groove and the external thread of the fastening element is arranged closer than the height of the groove to the inner surface of the sleeve-like array (= the inner surface of the hole). When the height of the grooving and the fastening element driven within the sleeve-like array are chosen in the above way, the advantage is provided that the fastening element provided with an external thread bites equally deep into each groove of the grooving.

The shape of the cross-section profile of the grooves of the grooving is advantageously chosen such that the material displaced by the external threads of the fastening element is effortlessly carried along to the slots of the grooving. In an advantageous embodiment of the invention, the cross-section profile of the grooves is of the shape of a truncated cone.

Furthermore to decrease the torque intended to drive the fastening element and to make the fastening element run within the sleeve-like array such that the centre line of the screw element goes about along the centre line of the sleeve-like array, the number of groovings on the inner surface of the sleeve-like array in an advantageous embodiment of the invention has been made to depend on the inner diameter of the screw tower. If the diameter of the screw tower is larger, the number of groovings can be increased and, when the diameter is smaller, the number of groovings has to be decreased equivalently. A suitable number of groovings is usually 5-9, depending on the inner diameter of the sleeve-like array.

By providing the sleeve-like array manufactured of hard plastic, such as polycarbonate, with longitudinal grooves protruding from the inner surface of the array, the stress applied on the housing of the array, i.e. its longitudinal walls, is substantially decreased because, when driving the fastening element provided with an external thread within the sleeve-like array, the material displaced from the inner surfaces of the array is able to be carried along to the slots between the grooves and does not remain between the external thread and the inner surface of the sleeve-like array to increase the bending stress applied to the housing of the sleeve-like array.

The invention provides a considerable advantage particularly in the series production of enclosures. The lid section and the base section of the enclosure are joined to each other mechanically similar to the joining section joining the lid section and the base section of the enclosure to each other. The manufacture of enclosures employs specific torque to fasten the screw elements to their counterparts (sleeve-like array). The groovings prevent the housing of the sleeve-like array from fracturing during the manufacture of the enclosure or after it, because a) it is possible to use torque smaller than usual for driving the screw element compared to a situation in which traditional sleeve-like arrays were used as the counterparts of the screw elements, and b) no material increasing the bending stress remains between the screw element and the housing of the sleeve-like array. A further advantage of the decreased torque is the lowered power consumption and quicker enclosure manufacture.

The invention will now be described in more detail with reference to the accompanying figures.
Fig. 1A shows a perspective view of a plastic enclosure which is provided with a latch and a hinge section.
Fig. 1B shows the plastic enclosure of Fig. 1A seen from the direction IB of Fig. 1A.
Fig. 1C shows a top view of one of the screw towers in Fig. 1A.
Fig. 2A shows a perspective view of the hinge section of the plastic enclosure of Fig. 1 which has four screw towers.
Fig. 2B shows a top view of the hinge section of Fig. 2A when the hinge section is turned totally open.
Fig. 3A shows a hinge section partially cut open.
Fig. 3B shows a hinge section partially cut open with fastening screws fastened.
Fig. 4 shows a perspective view of the latch section of Fig. 1 which has three screw towers.

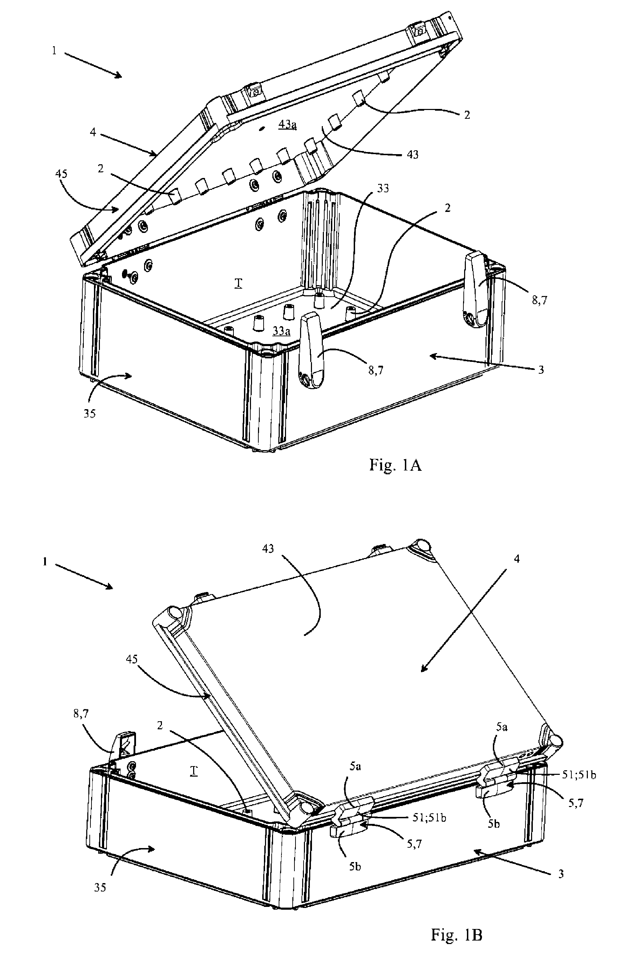

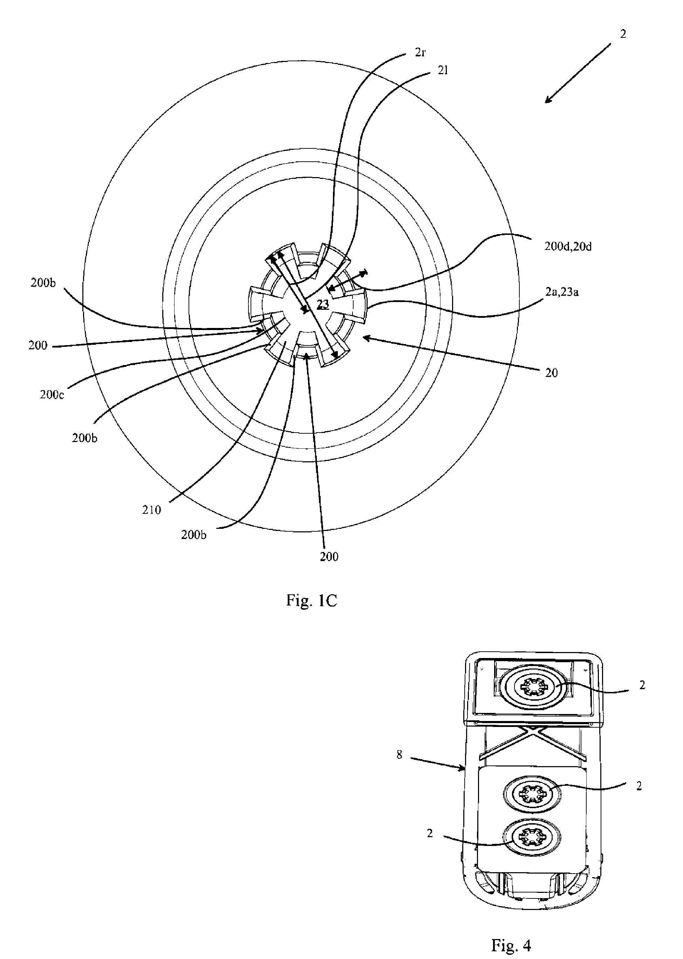

Next, the main parts of structures shown in Figs. 1-4 and what each figure is intended to illustrate will be described.

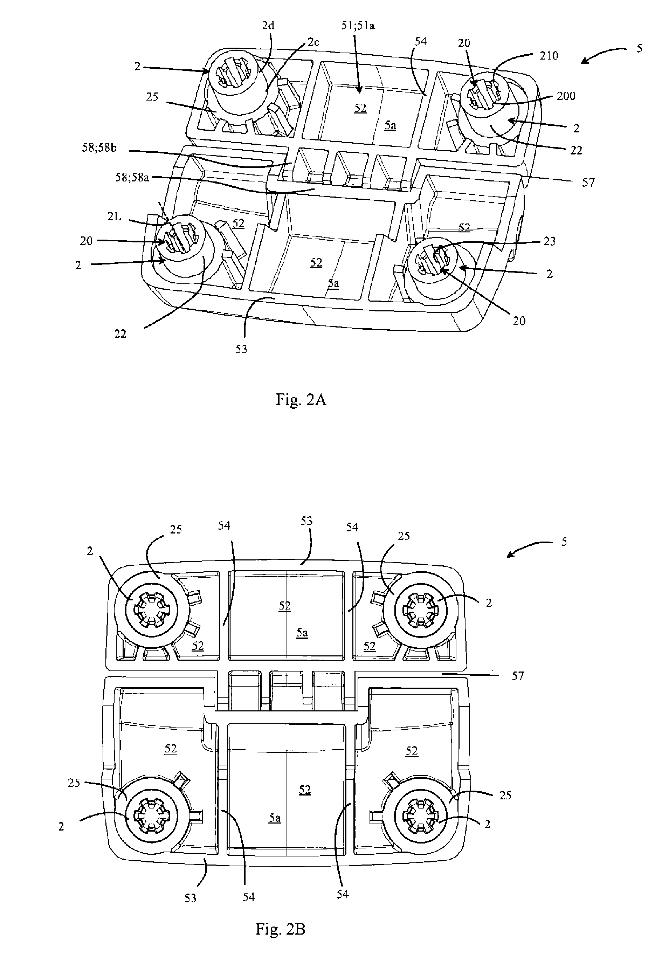

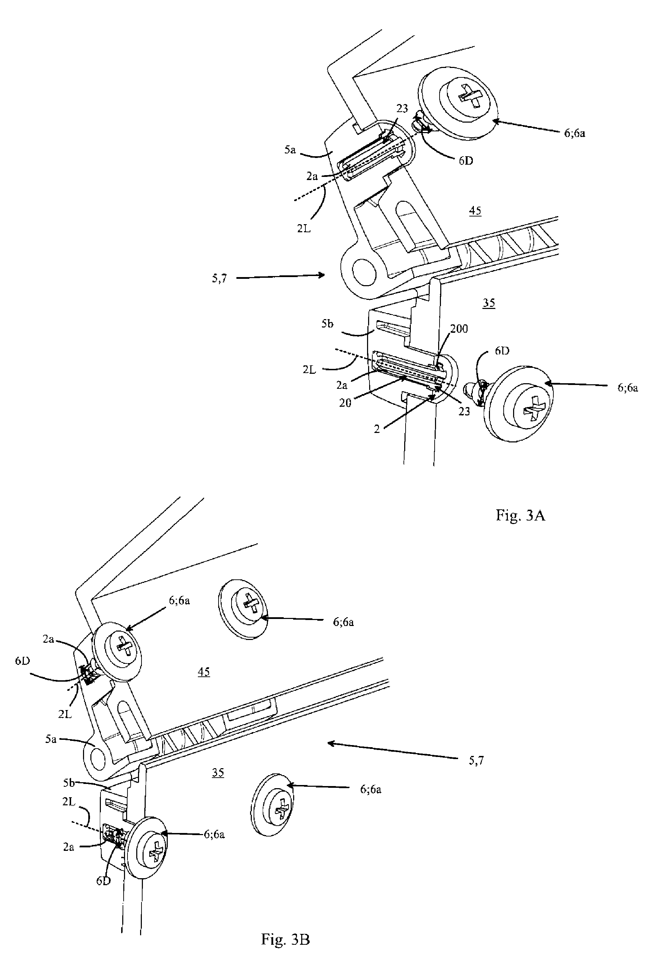

Figs. 1A and 1B show a general view of a plastic enclosure 1 which consists of a lid section 4 and a base section 3 mutually joinable which are detachably joined to each other by means of two hinge sections 5 and lockably by means of two latch sections 8. The hinge and latch sections 5, 8 of a joining section 7 are located on the opposite longitudinal sides of the enclosure 1. The lid section 4, the base section 3, the hinge section 5 and the latch section 8 employ screw towers 2 as the counterparts of fastening elements provided with an external thread, which are better visible in Figs. 2A-2B, 3A-3B and 1C. Both the hinge section 5 and the latch section 8 are fastened to both the lid section 4 and the base section 3 with coarse-thread screws the counterpart of which is equivalently the screw tower 2 supporting itself on the inner surface of the hinge section 5 and the latch section 8. Fig. 1A shows a rectangular, planar base 33 of the base section 3 and four similar, rectangular base walls 35 joined to it at a 90-degree angle. Between the base section 3 and the lid section 4 remains a space T when the lid is closed. On an inner surface 33a of the base 33 are located a set of screw towers 2 to which various attachments and accessories can be fastened. Fig. 1A also shows a rectangular, planar lid 43 of the lid section 4 which is simultaneously the lid 43 of the enclosure 1 and four rectangular lid walls 45 of the same height joined to the lid 43. The edges of an inner surface 43a of the lid 43 are circulated by a set of screw towers 2 at an even distance from each other, the structure and use of which is similar to the screw towers of the base section 3. Fig. 1C shows a top view of the structure of one screw tower 2 shown in Fig. 1A and a butt 25 supporting the screw tower. On the inner surface of the screw tower 2, there is a grooving 20 which consists of six grooves having a cross-section profile of the shape of a truncated cone and slots between them. The structure of the grooving is also visible in Figs. 2A-2B and 3A-3B. Figs. 2A and 2B illustrate the hinge section 5 and the screw towers 2 in it. The hinge section 5 consists of a lower part 5b of the hinge section fastenable to the base section 3 of the plastic enclosure and an upper part 5a of the hinge section fastenable to the lid section 4 of the plastic enclosure between which remains a gap 57 in the longitudinal direction of the hinge around which the lower part 5b and the upper part 5a of the hinge section can be turned in relation to each other by means of a hinge mechanism 58. The hinge section 5 joins the base section 3 and the lid section 4 of the plastic enclosure 1 shown in Figs. 1A and 1 B. On an inner surface 51 a of the frame of the hinge section 5 turned in the direction of the plastic enclosure 1 are located four similar screw towers 2.

Figs. 3A and 3B again show how a coarse-thread screw element 6a penetrates the grooving 20 which comprises a set of grooves 200 on the inner surface of the screw tower 2, when the hinge section 5 is fastened to the base or lid section by pressing the screw element from inside the plastic enclosure 1 through equivalent base and lid walls 35, 45 and further to the screw towers 2 provided with grooves of the hinge section 5. The hinge section 5 is fastened to the base section 3 and the lid section 4 of the plastic enclosure 2 by the coarse-thread screws 6a.

Fig. 4 shows one of the latch sections 8 shown in Fig. 1A as enlarged. The latch section 8 can fasten the lid section 4 and the base section 3 of the enclosure mutually lockably. The latch section 53 is then fastened on the outer surface of one lid wall of the lid section 4 with screw elements provided with an external thread in a way similar to the hinge section 5 by pushing the screw element from inside the enclosure through said lid wall to the screw towers 2 provided with the grooving 20 of the latch section 8.

Next, the invention will be described in more detail with reference to Figs. 1-4 and their above general description.

Figs. 1A and 1B show a plastic electrical component enclosure 1 joinable e.g. to installation guides fastened to a wall. The lid section 4 of the plastic enclosure 1 consists of a rectangular-shaped, planar lid 43 and the lid walls 45 joined to the lid at a straight angle which comprise four slightly profiled lid walls. The base section 3 consists of a planar, rectangular-shaped base 33 and four rectangular-shaped base walls 35 joined to the base at a 90-degree angle. The lid walls 45 of the lid section 4 are fittable on top of the base walls 35 of the base section 3 such that between the lid section 4 and the base section 3 remains a specific interior space T the height of which is the same as the combined height of the lid walls 45 and the base walls 35. The plastic enclosure 1 thus closed consists of the base 33 and the lid 43 and the vertical walls 35, 45 between the base and the lid which walls again consist of the lid walls 45 and the base walls 35.

The material of the plastic enclosure 1 is hard polycarbonate or fibreglass-reinforced polycarbonate, which is thermoplastic resin, with the melting temperature of about 260°C-300°C in die-casting, the bending modulus of about 2,400-3,600 MPa (ISO 527) and the tensile strength of (ISO-527) 5-7 MPa. Suitable ones include unmixed and mixed polycarbonate resins sold by the trade names of Makrolon, Xantar and Lexan of which it is possible to manufacture equivalent thermoplastics by die-casting. The notch strength of mixed polycarbonate plastics is higher than that of pure polycarbonate plastics, but their hardness is again slightly lower than that of polycarbonate-based plastics.

Fig. 1A shows the base section 3 and the lid section 4 onto the base of which is arranged a set of screw towers 2 circulating the base, the structure of which is similar to the one of the screw towers of the hinge section 5 described later. These base and lid section screw towers 2 can be attached with various accessories such that the fastening screw is driven through the accessory and further via the free end of the screw tower within the screw tower, such as shown in Figs. 3A and 3B. It is also possible to use the screw towers shown in Fig. 1A to fasten the enclosure to an external target, such as on installation rails. Then, the fastening screw is pushed via the free end of the screw tower within the screw tower and further through the closed end and simultaneously the base of the screw tower to a counterpart in the installation rail.

Figs. 2A and 2B and 3A and 3B show in more detail the structure of the hinge section 5, its way of fastening to the lid section 4 and the base section 3 and the screw towers 2 in the hinge section 5. The general shape of the hinge section 5 is rectangular. Its upper part 5a and lower part 5b both consist of a part even of its outer surface and rectangular of its general shape. The upper part 5a and the lower part 5b are fastened to each other with a hinge mechanism 58 which comprises a stem 58a fastened on the inner edge of the lower part and a set of projections 58b fastened on the inner edge of the upper part some of which penetrate within the stem. The stem 58a and the projections 58b are mutually fastened with a fastening which enables the upper and lower part of the hinge section to turn in relation to each other around a gap between them in the longitudinal direction of the hinge. The hinge mechanism 58 is best visible in Figs. 2A and 2B. The lower part 5b and the upper part 5a of the hinge section 5 can be turned in relation to each other from a position in which the lower part 5b and the upper part 5b of the hinge section are at a 90-degree angle in relation to each other and the plane defined by the lid 43 constitutes a 90-degree angle with the plane going through the base 33 (the enclosure is in the open position) between an angle of about 180 degrees, whereby the plane of the lid 43 is about in the same direction with the plane going through the base 33 (the plastic enclosure is closed).

The outer surface of the hinge section 5 refers to an even outer surface 51 b of a planar frame 51 of the hinge section which is directed away from the plastic enclosure 1 when the hinge section 5 is installed in place in the enclosure. Inside both the lower part 5b of the hinge section 5 and the upper part 5a of the hinge section 5 are formed three recesses 52 of which to the farthest recesses in the longitudinal direction of the hinge section 5 are located the screw towers 2. The recesses 52 are formed with an outer trim 53 circulating the outer edge of the inner surface 51 a of the planar frame 51 of the hinge section and with partition walls 54 joined to the outer trim cross-directional to the hinge section. The outer trim 53 and the partition walls 54 protrude from the inner surface 51 a of the planar frame 51 at an angle of about 90 degrees inwards i.e. in the direction of the plastic enclosure after the hinge section 5 has been installed in place. The depth of each recess 52 is defined by the height of the outer trim circulating the lower part 5b and the upper part 5a of the hinge section 5.

As mentioned above, there are screw towers 2 in the upper part 5a and the lower part 5b of the hinge section 5 in the two most outermost recesses 52, supporting themselves on the inner surface 51 a of the planar frame 51 of the upper and lower part 5a, 5b of the hinge section 5. The screw towers 2 of both hinge sections 5 are of the same shape and the same height and they equivalently diverge from the inner surface of the planar frame 51 of the upper and lower part 5a, 5b of the hinge section 5 at a 90-degree angle such that they direct straight towards the outer surface 51 b of the lower and upper part 5b, 5a of the plastic enclosure, when the lower and upper part 5b, 5a of the hinge section 5 are equivalently fastened in place to the base section 3 and the lid section 4 of the enclosure 1. In Fig. 2B, the hinge section 5 is in its totally open position, whereby the inner surfaces of the lower part 5b and the upper part 5a of the hinge section 5 are on the same plane. The view of Fig. 2B is directly onto the inner surface 51 a of the planar frame 51 of the lower and upper part of the hinge section 5 from where the screw towers 2 seem to arise directly upwards. As it can be seen from Figs. 2A and 2B, the butt 25 supporting the lower part of each screw tower 2 supports itself partially on the inner surface 51 a of the planar frame 51 and partially on the outer trim 53 circulating the lower and upper part 5b, 5a of the hinge 5. The butt 25 supporting the screw tower 2 is sheath-like, having an approximately circular cross-section profile, surrounding the lower part of the screw tower 2. The upper surface of the sheath-like butt 25 is even and the butt has been reinforced by providing it with projections diverging from the outer circle the lower surface of which supports itself on the planar frame 51.

As best seen from Figs. 2A-2B, 3A-3B and 1C, each screw tower 2 comprises an array being sleeve-like, such as bar-like, tube-like or tower-like, having an approximately circular cross-section profile. A first closed end 2c (next also lower end) of the screw tower 2 supports itself on a plane surface, here on the planar frame 51 of the hinge-section lower part 5; 5b or hinge-section upper part 5; 5a. A frame (next also the screw tower housing) 22 and a free end 2d of the screw tower 2 direct at a 90-degree angle away from said plane surface.

On the inner surface 2a of the screw tower 2 goes the grooving 20 which comprises a set of substantially straight grooves 200 in the longitudinal direction of the screw tower 2 which are at the same peripherical distance of the inner surface 2a of the screw tower 2 from each other and also slots 210 remaining between the grooves. Each groove 200 further consists of a straight, elongated projection diverging from the inner surface of a hole 23 going in the middle of the screw tower 2 at a distance 200d. At the distance of 200d from the inner surface in the direction of the radius 2r of the hole 23 is located a front edge 200c of the groove. The height of the groove is its dimension in the direction of the hole radius. In each groove 200, there are two walls 200b slanting towards each other which are fastened first on the inner surface 2a of the hole 23 and second to the front edge of the groove. The walls of each slot 210 always consist of the walls 200b of two adjacent grooves 200 and the base of the slot consists of the inner surface 2a of the screw tower remaining between said grooves (= the inner surface of the hole 23).

The purpose of the grooving 20 is first to guide the fastening element provided with an external thread 6 to go controlledly within the screw tower 2 such that the longitudinal centre line of said fastening element goes as close as possible to a longitudinal centre line 2L of the screw tower 2 (i.e. the fastening element is centred on the centre line 2L of the screw tower).

The purpose of the grooves 200 of the grooving is also to decrease the torque by which the fastening element provided with an external thread 6, such as a screw 6a, can be driven within the screw tower 2, which decreases the bending stress applied to the housing 22 of the screw tower 2. For this purpose, the number and shape of the grooves 200, and the height 200d of the grooves 200 in the direction of the radius 2r of the hole 23 going through the screw tower 2 must be chosen such that the material displaced by the external thread of the fastening element 6 from the grooves 200 of the grooving 20 is able to be carried along to the slots 210 between the grooves, but the fastening element 6 still forms a permanent friction joint with the grooves 200 of the grooving 20.

The grooving 20 usually runs for almost the whole length of the screw tower. For instance in the screw towers shown in Figs. 3A and 3B, the length of the whole screw tower is 10.5 mm, whereby the grooving 20 could extend e.g. in the depth of 10 mm seen from the free end 2d of the screw tower.

To centre the fastening element 6 on the centre line 2L of the sleeve-like array, the proportion of the outer diameter of the fastening element 6 used and the inner diameter 2I of the screw tower 2 (i.e. the diameter of the hole 23 going through the screw tower) should be first chosen such that the outer diameter of the fastening element 6 is substantially smaller than the inner diameter of the screw tower. The thus chosen fastening element 6 is not substantially in contact with the inner surface 2a of the hole going through the screw tower 2 when the fastening element 6 is centred on the centre line 2L in the longitudinal direction of the screw tower 2. For instance, the inner diameter of the screw tower 2 shown in Fig. 3B is about 5 mm, whereby the outer diameter of the coarse-thread screw 6a to be driven within can be e.g. about 4 mm.

To centre the fastening element 6 on the centre line of the screw tower 2 and to provide a durable friction joint between the fastening element 6 and the grooving 20, the height 200d of the grooves 200 on the inner surface of the hole 23 going through the screw tower 2 in relation to the inner and outer diameter of the fastening element 6 should be arranged such that the fastening element 6 being on the longitudinal centre line of the screw tower 2 bites equally deep in each groove 200. The height 200d of the groove 200 and the height 20d of the grooving refer here to how far the groove 200 or the grooving 20 extends in the direction of the radius 2r of the hole 23 of the screw tower (sleeve-like array) 2 from the inner surface 2a of the screw tower 2 and simultaneously the hole 23. Due to this, the height 20d of the grooving 20 in the screw tower having the inner diameter 2l and simultaneously the height 200d of each groove 200 should be such that an outer diameter 6D of the fastening element provided with an external thread 6 (fastening element diameter 6D at the point of the main thread) should be such that the equation 6D > 2I - 2 x 20d holds. In words, this means that the outer diameter 6D of the fastening element 6 should be so large that the external thread of the fastening element 6 set on the centre line 2L of the hole 23 of the screw tower in the longitudinal direction extends within the grooving 20 when the grooving 20 is seen from said centre line 3L in the direction of the hole radius 2r. At the same time, an inner diameter 6d of the fastening element should still be such that the equation 6D<= 2I - 2 x 20d holds. In words, this means that the inner diameter 6D of the fastening element 6 should be such that the part without an external thread of the fastening element 6 extends at the most until the grooving 20 when the fastening element is located on the centre line 2L of the hole 23 of the screw tower 2 and the grooving 20 is seen from said centre line 2L in the direction of the radius 2r. The grooving 20 and the fastening element 6 dimensioned this way provide for that the centre line of the fastening element 6 is all the time approximately on the centre line 2L of the hole 23, as the front edge 200c of the grooves 200 prevents the centre line of the fastening element 6 from drifting aside from the centre line 2L of the screw tower and, furthermore, the external thread of the fastening element 6 bites evenly in the grooving 20.

For instance, when the outer diameter of the screw tower 2 is 10 mm and the diameter of the hole 23 running within the screw tower is 5 mm, a suitable groove height is 0.75 mm. Then, it is possible to use a screw with the outer diameter of above 3.5 mm, e.g. 4 mm. The inner diameter of the screw could then be below 3.5 mm, e.g. 2.5 mm.

The number of the grooves 200 in the grooving 20 circulating the inner surface of the screw tower 2 or the sleeve-like array affects the magnitude of torque required to drive the screw. The number of the grooves 200 in the grooving depends on the inner diameter of the screw tower such that, if the inner diameter 2I of the screw tower 2 is larger, the number of the grooves 200 can be increased and, when the inner diameter 2I is smaller, the number of the grooves 200 can be equivalently decreased. The number of the grooves 200 in the grooving 20 should be kept such that the material of the grooves 200 displaced by the external thread of the fastening element 6 is effortlessly carried along to the slots 210 between the grooves. A suitable groove number is usually 5-9. In the embodiment of the invention shown in the figures, the grooving 20 consists of six straight grooves 200 running on the inner surface of the screw tower 2, in the longitudinal direction of the screw tower. The adjacent grooves are at the same peripherical distance from each other. If the grooves were set asymmetrically peripherically, it might hinder the centering of the fastening element on the centre line 2L. The peripherical distance refers here to the distance of the middles of adjacent grooves 200 from each other, measured along the inner surface of the hole 23 of the screw tower 2, which hole 23 has a specific inner diameter 2I. Furthermore, the grooving 20 includes six slots 210 running between the grooves 200, containing the inner surface 2a of the hole 23.

In addition, the shape of the cross-section profile of the grooves 200 of each grooving 20 is chosen advantageously such that the material displaced by the external threads of the fastening element 6 from each groove 200 is effortlessly carried along to the slots 210 of the grooving 20 to decrease the torque required to drive the fastening element 6 but still such that a durable friction joint is created between the fastening element and the grooving of the sleeve-like array. The cross-section profile of the groovings shown in Figs. 2A-2B, 3A-3B and 1C is of the shape of a truncated cone, whereby the base of said truncated cone supports itself on the inner surface of the screw tower. Then, each groove 200 includes two walls 200b slanting towards each other from the inner surface 2a of the hole 23 which are fastened on the front edge 200c of the groove. As shown in Figs. 2A-2B, 3A-3B and 1C, the grooves 200 usually start from the free end of the screw towers and extend almost to the whole longitudinal dimension of the screw tower 2.

The wall thickness of the actual screw tower 2 is most commonly the same for the whole length of the screw tower 2. It is still possible to slightly decrease the material thickness at the free end 2d of the screw towers 2, if the free end of the screw tower 2 is desired e.g. to centre the screw element to run precisely along the longitudinal centre line of the screw tower.

Figs. 3A and 3B show how the coarse-thread screw element 6a penetrates the screw tower 2 when the upper and lower part 5a, 5b of the hinge section 5 are fastened to the base and lid section 3, 4 of the plastic enclosure by pressing the screw elements 6a from inside the enclosure through the base and lid walls 35, 45 and further to the screw towers provided with grooves 20 of the hinge section 5. The hinge section 5 is fastened to the base section 3 and the lid section 4 of the enclosure by the coarse-thread screws.

When the screw element 6a is driven within the screw tower 2, the screw element displaces material from the screw tower according to the invention and not from the walls 2a of the screw tower, such as in conventional screw towers, whereby it is also possible to keep the torque required to drive the screw element 6a smaller. The screw element driven within the screw tower 2 comprises a thread coarse of its outer surface, such as shown in Fig. 3B, which further decreases the torque required to drive the screw.

Fig. 4 again shows the structure of the latch section 8 in more detail. The latch section includes three screw towers 2 the structure and operation of which is similar to the screw towers in the hinge section.

Even though the invention was illustrated above only by way of screw towers, which are manufactured of polycarbonate-based plastic materials by die-casting, it is evident to those skilled in the art that the invention can be implemented in many other ways within the scope of the invention presented in the claims.

Therefore, the applicant has found that also other die-cast screw towers manufactured of hard, thermoplastic plastics include similar fracturing problems as the screw towers manufactured of polycarbonate-based plastics. The durability of the screw towers of plastic enclosures manufactured of these materials can also be improved by providing them with groovings. Hard plastics here refer that their Rockwell hardness is above M60, advantageously above 70, bending strength (psi) above about 7,000 and Izod impact strength (ft.lb/in) above 0.3, advantageously above 8. Depending on the extent of mixing of the plastic grade, the different types of the same plastic grade can belong to 'hard' plastics and some to 'soft' plastics. In addition to polycarbonate, the 'hard' plastic grades can include e.g. methacrylate-based, polyether-ketone-based, polystyrene-based and ABS-based plastic grades, still not limited to these.

In the embodiment of the invention shown above in Figs. 1-4, the lower end 2b of the sleeve-like array supports itself on the plane surface and is closed. It is still possible that the lower end of the sleeve-like array abuts on the plane surface and is open, by making an opening to the lower end abutting on the plane surface of the sleeve-like array from which the fastening element provided with an external thread can be driven to a suitable accessory, such as a installation rail of the plastic enclosure 1.

### List of reference numbers

| | |
|---|---|
| Plastic enclosure | 1 |
| Sleeve-like array | 2 |
| Inner surface of sleeve-like array | 2a |
| Lower end, end abutting on plane surfaceof sleeve-like array | 2c |
| Free end of sleeve-like array | 2d |
| Inner radius of sleeve-like array | 2r |
| Inner diameter of sleeve-like array | 2l |
| Centre line of sleeve-like array | 2L |
| Groovings | 20 |
| Frame (or housing) of sleeve-like array or screw tower | 22 |
| Hole going through sleeve-like array | 23 |
| Inner surface of hole | 2a |
| Diameter of hole | 2l |
| Inner radius of hole | 2r |
| Centre line of hole | 2L |
| Height of groovings | 20d |
| Groove | 200 |
| Wall of groove | 200b |
| Front edge of groove | 200c |
| Height of groove | 200d |
| Slot of grooving | 210 |
| Slot of grooving | 210 |
| Butt of sleeve-like array | 25 |
| Base section of plastic enclosure | 3 |
| Base of base section, base of enclosure | 33 |
| Inner surface of base of base section, base of enclosure | 33a |
| Walls of base section | 35 |
| Lid section of plastic enclosure | 4 |
| Lid of lid section, lid of enclosure | 43 |
| Inner surface of lid of lid section, lid of enclosure | 43a |
| Walls of lid section | 45 |
| Hinge section | 5 |
| Upper part of hinge section | 5a |
| Lower part of hinge section | 5b |
| Frame of hinge section | 51 |
| Inner surface of frame of hinge section | 51a |
| Outer surface of frame of hinge section | 51b |
| Recess of hinge section | 52 |
| Outer trim of inner surface of frame | 53 |
| Partition wall of inner surface of frame | 54 |
| Gap in hinge section | 57 |
| Hinge mechanism | 58 |
| Stem of hinge mechanism | 58a |
| Projections of hinge mechanism | 58b |
| Fastening element provided with external thread | 6 |
| Coarse-thread screw | 6a |
| Outer diameter of screw | 6D |
| Joining section | 7 |
| Latch section | 8 |
| Interior space of plastic enclosure | T |

## Claims

1. A plastic enclosure (1), which comprises a base section (3) and a lid section (4) which form, the enclosure being closed, a base (33) and a lid (43) of the enclosure, and walls (45, 35) remaining between said lid (43) and base (33), whereby on an inner surface (33a, 43a) of the enclosure base (33) or lid (43) or an inner surface of a joining section (7) used for the mutual joining of the enclosure (1) base section (3) and lid section (4) abuts at least one sleeve-like array (2) protruding from the plane of the inner surface/inner surfaces in question at an angle of about 90 degrees, which is arranged to receive a fastening element with an external thread (6), **characterised in that** from an inner surface (2a) of the sleeve-like array (2) protrudes in the direction of a radius (2r) of the sleeve-like array (2) a set of elongated grooves (200) in the longitudinal direction of the sleeve-like array.

2. A plastic enclosure (1) according to claim 1, **characterised in that** the plastic enclosure (1), the possible enclosure joining section (5) and the sleeve-like array (2) are manufactured of substantially hard, incompressible thermoplastic, such as polycarbonate plastic or mixed polycarbonate plastic, with such a melting point that it is die-castable, whereby the Rockwell hardness of the plastic is above 60, advantageously above 70, and its bending strength is above 60 MPa (ISO 527).

3. A plastic enclosure (2) according to claim 2, **characterised in that** on the inner surface (2a) of the sleeve-like array there is a grooving (20) which includes a set of straight grooves (200) running on said inner surface, in the longitudinal direction of a screw tower which protrude in the direction of the radius (2r) of the sleeve-like array (2) from said inner surface (2a) such that the adjacent grooves (200) are always at the same peripherical distance from each other and, further, the grooving includes a set of slots (210) running between the grooves (200), including the inner surface (2a) of the sleeve-like array.

4. A plastic enclosure according to claim 3, **characterised in that** the walls of each slot (210) always consist of the walls (200b) of two adjacent grooves (200) and the base of each slot (210) consists of the inner surface (2a) of the sleeve-like array remaining between said grooves.

5. A plastic enclosure (1) according to any one of claims 1-4, **characterised in that** the sleeve-like array (2) is a screw tower the structure of which is circular of its cross-section profile, hollow from inside, being bar-like, tube-like or tower-like, the lower end (2b) of which abuts on a plane surface and the other free end (2c) directs towards an interior space (T) of the plastic enclosure (1), and on the inner walls (2a) of which sleeve-like array (2) support themselves a set of grooves (200) which run at the same peripherical distance of the cross-section profile from each other.

6. A plastic enclosure (1) according to claim 5, **characterised in that** the wall thickness of the sleeve-like array (2) is mainly the same for the whole length of the sleeve-like array.

7. A plastic enclosure (1) according to any one of claims 1-6, **characterised in that** each groove (200) is of its cross-section profile of the shape of a truncated cone, whereby the base of the truncated cone supports itself on the inner wall (2a) of the sleeve-like array (2).

8. A plastic enclosure (1) according to any one of preceding claims, **characterised in that** the number of grooves (200) on the inner surface (2a) of the sleeve-like array (2) is 4-10, advantageously 5-9, depending on an inner diameter (21) of the sleeve-like array (2).

9. A plastic enclosure (1) according to any one of preceding claims, **characterised in that** the lower end (2b) of the sleeve-like array (2) is closed and supports itself on the base of the enclosure base section or the lid of the enclosure lid section and a frame (22) of the sleeve-like array protrudes from said base or lid at an angle of about 90 degrees in the direction of the interior space (T) of the plastic enclosure.

10. A plastic enclosure (1) according to any one of preceding claims 1-9, **characterised in that** the enclosure (1) includes a joining section (5), which is a hinge section (5) intended to the mutual hinging of the base section and the lid section, from an inner surface (51 a) of a planar frame (51) of which protrudes at a 90-degree angle, when the hinge section (5) is joined to the base section (3) and the lid section (4), the sleeve-like array (2) in the direction of the enclosure (1).

11. A plastic enclosure (1) according to any one of preceding claims, **characterised in that** the lower end (2b) of the sleeve-like array (2) supports itself on the plane surface and is provided with a butt (25) reinforcing the sleeve-like array.

12. A plastic enclosure (1) according to claim 11 or 12, **characterised in that** the sleeve-like array (2) is integrated of its housing to the other structure of the enclosure (1) or its joining section (5).

13. A joint (8) between the sections of a plastic enclosure (1), whereby the plastic enclosure (1) comprises a base section (3) and a lid section (4) which form, the enclosure (1) being closed, an enclosure base (33) and lid (43), and walls (45, 35) of the plastic enclosure remaining between said lid and base, whereby on an inner surface of a joining section (7) used for the mutual joining of the base section (3) and the lid section (4) of the enclosure abuts at least one sleeve-like array (2) protruding from the plane of the inner surface/surfaces in question at an angle of about 90 degrees, which is arranged to receive a fastening element provided with an external thread (6) and the joint (8) is formed by means of said fastening element provided with an external thread (6) which is fitted within the sleeve-like array (2) abutting on said inner surface of the joining section (7) such that it also simultaneously goes through the wall (35, 45) of the plastic enclosure (1), **characterised in that** from an inner surface of the sleeve-like array (2) protrudes in the direction of a radius (2r) of the cross-section profile of the sleeve-like array (2) a set of elongated grooves (200) in the longitudinal direction of the sleeve-like array (2) to guide the fastening element provided with an external thread (6) on a longitudinal centre line (2L) of the sleeve-like array (2).

14. A joint (8) between the plastic enclosure (1) and an accessory or an attachment, whereby the plastic enclosure (1) comprises a base section (3) and a lid section (4) which form, the enclosure (33) being closed, an enclosure base (33) and lid (43), and walls (45, 35) of the plastic enclosure remaining between said lid and base, whereby on an inner surface (33a, 43a) of the enclosure base (33) or lid (43) abuts at least one sleeve-like array (2) protruding from the plane of the inner surface/surfaces (33a, 43a) in question at an angle of about 90 degrees, which is arranged to receive a fastening element provided with an external thread (6) and which joint (8) is formed by means of said fastening element provided with an external thread (6) which is fitted within the sleeve-like array (2) abutting on the inner surface of said base section (3) or lid section (4) such that it also simultaneously goes through the accessory or attachment, **characterised in that** from the inner surface (2a) of the sleeve-like array (2) protrudes in the direction of the radius (2r) of the cross-section profile of the sleeve-like array (2) a set of elongated grooves (200) in the longitudinal direction of the sleeve-like array (2) to guide the fastening element provided with an external thread (6) on a longitudinal centre line (2L) of the sleeve-like array (2).

15. A joint (8) according to claim 13 or 14, **characterised in that** on the inner surface (2a) of the sleeve-like array (2) supports a set of grooves (200) which run at the same peripherical distance of the cross-section profile from each other,
the outer diameter of the fastening element provided with an external thread (6) brought within the sleeve-like array (2) is arranged smaller than the inner diameter (21) of the sleeve-like array (2) such that the fastening element (6) is not in contact with the inner surface (2a) of the sleeve-like array (2) when the fastening element (6) is centred on the longitudinal centre line (2L) of the sleeve-like array (2), the outer diameter of the fastening element (6) should still be at least such that it comes into contact with the grooves (200) arranged on the inner surface of the sleeve-like array.

16. A joint (8) according to any one of claims 13-15, **characterised in that** on the inner surface (2a) of the sleeve-like array there is a grooving (20) which includes a set of straight grooves (20) running on said inner surface, in the longitudinal direction of a screw tower, which protrude in the direction of the radius (200r) of the sleeve-like array (2), from said inner surface (2r) such that the adjacent grooves (200) are always at the same peripherical distance from each other and, further, the grooving includes a set of slots (210) running between the grooves (200), including the inner surface (2a) of the sleeve-like array.

17. A joint according to claim 16, **characterised in that** the number of grooves (200) on the inner surface of the sleeve-like array (2), the shape of the cross-section profile of each groove (200) and width (200d) in the direction of the radius (2r) of the cross-section profile of the sleeve-like array (2) are arranged such that material displaced by the external threads of the fastening element (6) from the grooves (200) is able to be carried along to the slots (210) to decrease the torque required to drive the fastening element (6) and that a durable friction joint is created between the fastening element (6) and the grooves (200) on the inner surface (2a) of the sleeve-like array (2).

18. A joint according to claim 16, **characterised in that** the height of the grooves (200) of the grooving (20) in the direction of the radius (2r) of a hole (23) within the sleeve-like array (2) in relation to the outer diameter of the fastening element provided with an external thread (6) is arranged such that the fastening element provided with an external thread (6) centred on the longitudinal centre line (2L) of the sleeve-like array (2) comes into contact with said grooves (200).

19. A joint (8) according to claim 17, **characterised in that** the height (200d) of each groove (200) from the inner surface of the sleeve-like array (2; 2a) is chosen such that the inner diameter of the fastening element provided with an external thread fittable in the hole going through the sleeve-like array is at the most equal to 2 times the groove height (200; 200d) to bring the unthreaded part of the fastening element in contact with the groove or close to it and to arrange the external thread of the fastening element (6) closer to the inner surface of the sleeve-like array (2; 2a) than the groove height (200; 200d).
